# EUROPEAN PATENT SPECIFICATION

(11) **EP 3 418 349 B1**
(45) Date of publication and mention of the grant of the patent: **26.08.2020**
(21) Application number: 18176100.8
(22) Date of filing: 22.10.2014
(51) Int. Cl.: C09K 11/80, C09K 11/08, H01L 33/50, C30B 29/28

(54) **PHOSPHOR-CONTAINING MEMBER AND LIGHT EMITTING DEVICE**
LEUCHTSTOFFHALTIGES ELEMENT UND LICHTEMITTIERENDE VORRICHTUNG
ÉLÉMENT CONTENANT DU LUMINOPHORE ET ÉLÉMENT ÉLECTROLUMINESCENT

(30) Priority: 23.10.2013 JP 2013220681
(43) Date of publication of application: 26.12.2018
(62) Divisional of application: 14855175.7
(73) Proprietor: Koha Co., Ltd., Tokyo 178-8511 (JP); National Institute for Materials Science, Tsukuba-shi, Ibaraki 305-0047 (JP)
(72) Inventor: INOMATA, Daisuke, Tokyo, 178-8511 (JP); ARAI, Yusuke, Tokyo, 178-8511 (JP); SANO, Hiroaki, Tokyo, 178-8511 (JP); AOKI, Kazuo, Tokyo, 178-8511 (JP); SHIMAMURA, Kiyoshi, Ibaraki, 305-0047 (JP); GARCIA VILLORA, Encarnacion Antonia, 305-0047, Ibaraki (JP)
(74) Representative: Betten & Resch

(56) References cited:
- WO-A1-2012/110009
- US-A1- 2010 090 583
- US-A1- 2010 301 739
- US-A1- 2011 068 680

## Description

### [Technical Field]

The invention relates to a phosphor-containing member and a light-emitting device.

### [Background Art]

A light-emitting device is known in which a light-emitting element including an LED (Light Emitting Diode) to emit a bluish light is provided together with a phosphor to be excited by the light of the light-emitting element and to emit a yellowish light such that the mixture of these emission colors gives a white light (see e.g. PTL **1** and PTL **2**).

The light-emitting device disclosed in PTL **1** uses a YAG: Ce polycrystalline phosphor ceramic sheet as the yellowish light-emitting phosphor.

The light-emitting device disclosed in PTL **2** uses a powder of Cerium-activated Yttrium Aluminum Garnet (YAG: Ce)-based polycrystalline phosphor as the yellowish light-emitting phosphor.

### [Citation List]

### [Patent Literature]

[PTL **1**]
   JP-A-**2010-24278**
[PTL **2**]
   JP-B-**3503139**

Document WO 2012/110009 A1 deals with the preparation of doped garnet structure single crystals with diameters of up to 500 mm. Preparation of lutetium and yttrium aluminate single crystals doped with rare earth oxides and transition elements consists in the preparation of oxide mixture sinter which is melted throughout and homogenized for a period of at least one hour. The single crystal seed has the minimum dimensions of 8 x 8 mm and length of 100 mm. The crystal growth rate and broadening of the crystal cone are maintained uniform at an angle of at least 60o from the crystal axis up to a diameter of at least 80% of the crucible diameter which is at least 100 mm. Thereafter the diameter thereof continues to be maintained by temperature regulation at the crystal/melt interface and by the crystal pulling and rotation speeds. The completion of the process occurs by separating the crystal from the melt while the crystal continues to be positioned inside the crucible in the zone wherein it was grown, and wherein final tempering of the crystal also takes place.

As further prior art, reference is made to US 2010/301739 A1, US 2011/068680 A1 and US 2010/090583 A1.

### [Summary of Invention]

### [Technical Problem]

It is an object of the invention to provide a phosphor-containing member having a YAG-based single crystal phosphor to produce fluorescence in an unconventional color, as well as a light emitting device including the phosphor-containing member. According to the invention this object is achieved by a phosphor-containing member according to claim 1 and a light emitting device according to claim 5.

### [Advantageous effects of the invention]

According to one embodiment, a YAG-based single crystal phosphor to produce fluorescence in an unconventional color can be provided as well as a phosphor-containing member and a light emitting device including the single crystal phosphor.

### [Brief Description of Drawings]

**[****FIG.1****]**

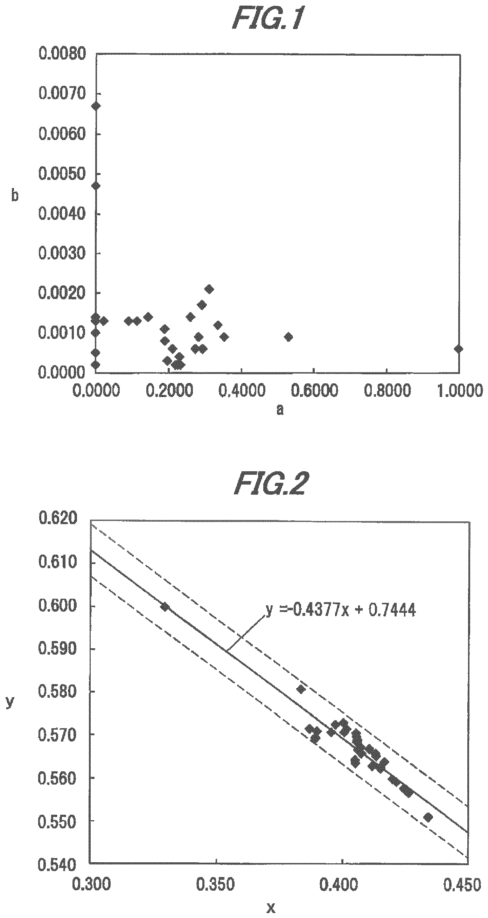

   **FIG.1** is a graph showing composition distribution in a single crystal phosphor in a first embodiment used for evaluation.
**[****FIG.2****]**
   **FIG.2** is a graph showing CIE (x, y) chromaticity distribution of the single crystal phosphor in the first embodiment used for evaluation.
**[****FIG.3A****]**

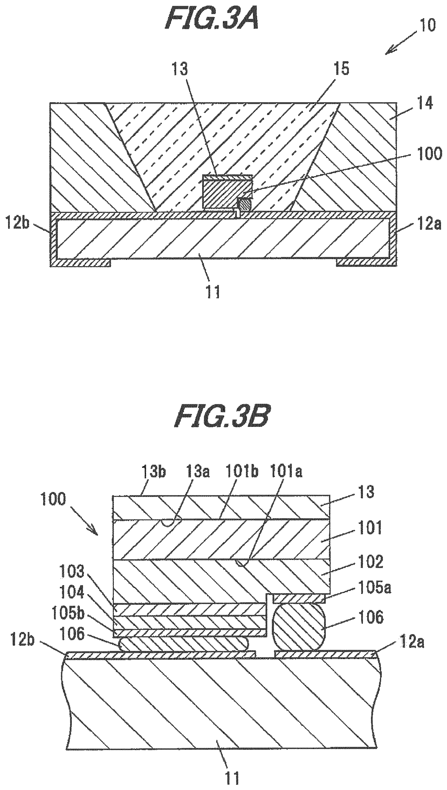

   **FIG.3A** is a vertical cross-sectional view showing a light-emitting device in a second embodiment.
**[****FIG.3B****]**
   **FIG.3B** is an enlarged view showing a light-emitting element and the periphery thereof in the light-emitting device.
**[****FIG.4****]**

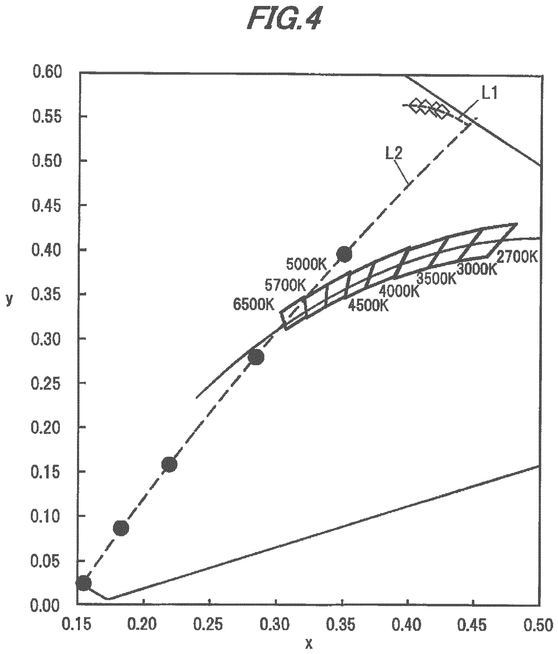

   **FIG.4** is a chromaticity diagram which plots the CIE chromaticity of light (fluorescence) emitted from the single crystal phosphor alone and the CIE chromaticity of a mixture light of light emitted from the light-emitting element and light emitted from the single crystal phosphor.
**[****FIG.5****]**

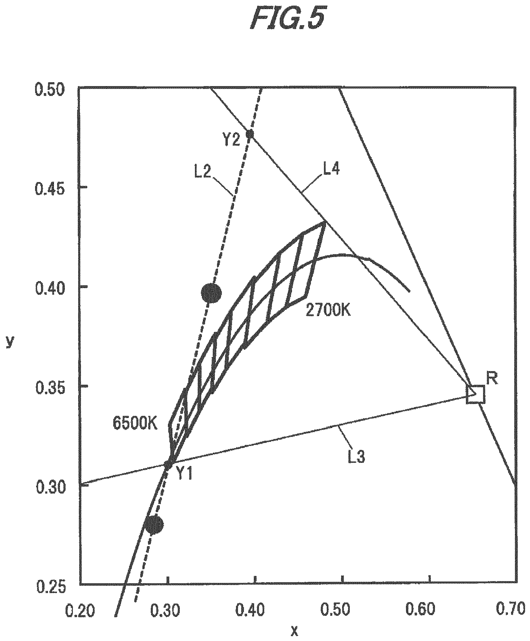

   **FIG.5** is a chromaticity diagram which plots the CIE chromaticity of a mixture light yielded by a combination of the light-emitting element, the single crystal phosphor and a reddish phosphor.
**[****FIG.6****]**

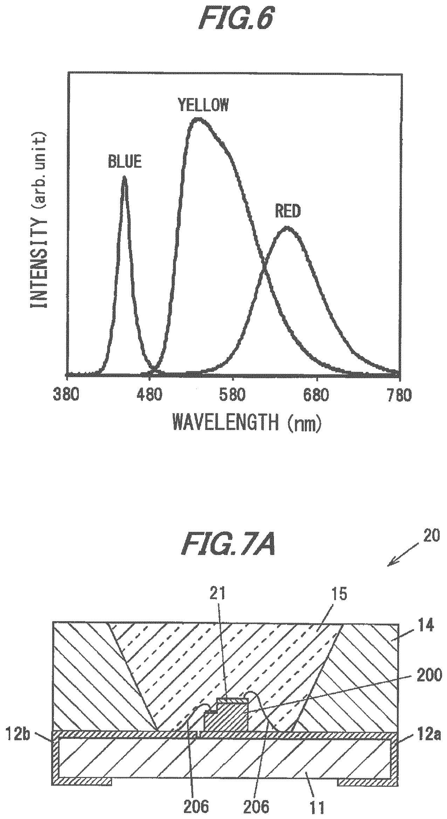

   **FIG.6** shows emission spectra of the light-emitting element, the single crystal phosphor and the reddish phosphor which were used for simulation (these spectra are referred to as "fundamental spectra").
**[****FIG.7A****]**
   **FIG.7A** is a vertical cross-sectional view showing a light-emitting device in a third embodiment.
**[****FIG.7B****]**

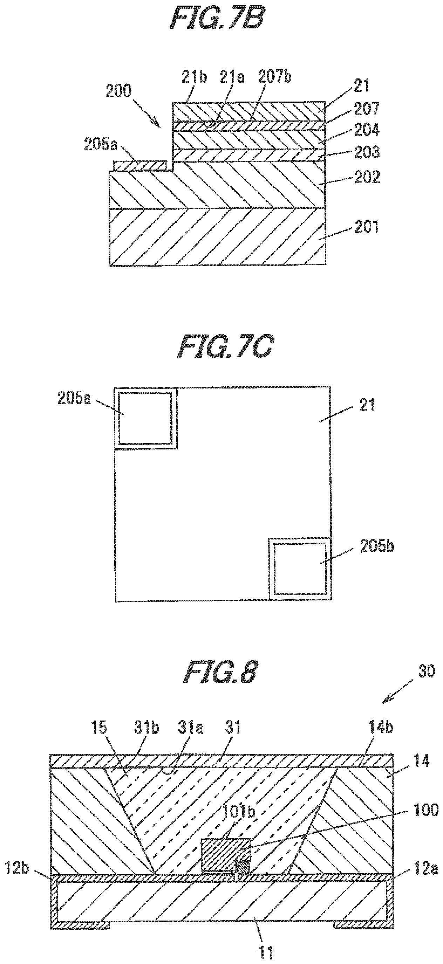

   **FIG.7B** is an enlarged view showing a light-emitting element and the periphery thereof in the light-emitting device.
**[****FIG.7C****]**
   **FIG.7C** is a top view showing the light-emitting element.
**[****FIG.8****]**
   **FIG.8** is a vertical cross-sectional view showing a light-emitting device in a fourth embodiment.
**[****FIG.9****]**

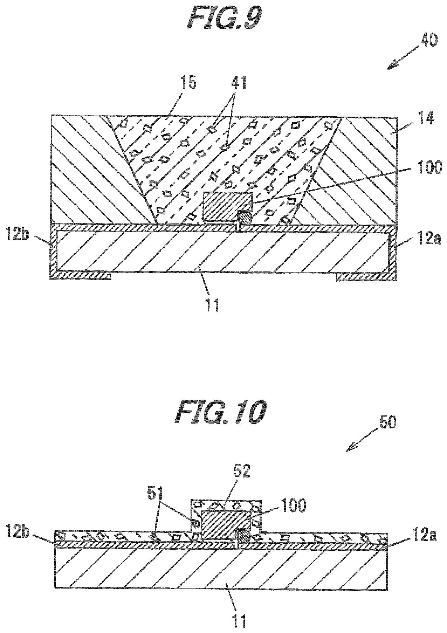

   **FIG.9** is a vertical cross-sectional view showing a light-emitting device in a fifth embodiment.
**[****FIG.10****]**
   **FIG.10** is a vertical cross-sectional view showing a light-emitting device in a sixth embodiment.

### [Description of Embodiments]

### [First embodiment]

### [Single crystal phosphor]

A single crystal phosphor in the first embodiment is a Ce-doped YAG-activated single crystal phosphor and has a composition represented by (Y_{**1**-a-b}LuₐCe_{b})_{**3**+c}Al_{**5**-c}O**₁₂** (where **0≤**a**≤0.9994, 0.0002≤**b**≤0.0067, -0.016≤**c**≤0.315).** Here, Ce is substituted in the Y site and functions as an activator (becomes the light emission center). On the other hand, Lu is substituted in the Y site but does not function as an activator.

In the composition of the phosphor, some atoms may be in different positions in the crystal structure. In addition, although the composition ratio of O in the compositional formula is **12,** the above-mentioned composition also includes compositions with an O composition ratio slightly different from **12** due to presence of oxygen which is inevitably mixed or deficient. In addition, the value of c in the compositional formula is a value inevitably variable when manufacturing the single crystal phosphor, but variation within a range of about **-0.016≤**c**≤0.315** have little effect on physical properties of the single crystal phosphor.

It is possible to obtain the single crystal phosphor in the first embodiment by, e.g., a liquid phase growth method such as CZ method (Czochralski method), EGF method (Edge Defined Film Fed Growth Method), Bridgman method, FZ method (Floating Zone method) or Verneuil method, etc. Ingots of single crystal phosphors obtained by such liquid phase growth methods are cut into flat plates or processed into powder, which are then available for manufacturing light-emitting devices described later.

The value of "b" indicating the Ce concentration in the above-mentioned compositional formula is in a range of **0.0002**≤a≤**0.0067** because when the value of b is smaller than **0.0002,** too low Ce concentration causes a decrease in absorption of excitation light and a resulting problem of an excessive decrease in external quantum efficiency and, when larger than **0.0067,** cracks or voids, etc., are highly likely to be generated during growth of an ingot of single crystal phosphor and thus cause a decrease in crystal quality.

### [Manufacture of single crystal phosphor]

A manufacturing method using the Czochralski process will be described below as an example of the method of manufacturing the single crystal phosphor in the present embodiment.

Firstly, Y₂O₃, Lu₂O₃, CeO₂ and Al₂O₃ each in the form of powder having a high purity (not less than **99.99%)** are prepared as starting materials and are dry-blended, thereby obtaining a mixture powder. In this regard, powder raw-materials of Y, Lu, Ce and Al are not limited to the above mentioned materials. In addition, when manufacturing a single crystal phosphor not containing Lu, the powder raw-material thereof is not used.

Next, the obtained mixture powder is put in a crucible made of indium and the crucible is then placed in a ceramic cylindrical container. Then, a high frequency energy of **30** kW is supplied to the crucible by a high-frequency coil wound around the cylindrical container to generate induced current, thereby heating the crucible. The mixture powder is melted and a melt thereof is thereby obtained.

Next, a seed crystal which is a YAG single crystal is prepared and, after bringing a tip thereof into contact with the melt, is pulled upward at a pulling speed of not more than **1** mm/h and rotated simultaneously at a rotation speed of **10** rpm at a temperature of not less than **1960**°C, thereby growing a single crystal phosphor ingot oriented to the <**111**> direction. The single crystal phosphor ingot is grown in a nitrogen atmosphere at atmospheric pressure in a state that nitrogen is being supplied at a flow rate of **2** L/min into the cylindrical container.

A single crystal phosphor ingot having, e.g., a diameter of about **2.5** cm and a length of about **5** cm is thereby obtained. By cutting the obtained single crystal phosphor ingot into a desired size, it is possible to obtain, e.g., a plate-shaped single crystal phosphor to be used in a light-emitting device. Or, by grinding the single crystal phosphor ingot, it is possible to obtain particles of single crystal phosphor.

### [Evaluation of single crystal phosphor]

Plural single crystal phosphors in the first embodiment which have different compositions were made. Then, analysis of the compositions and evaluations for CIE chromaticity and internal quantum efficiency were performed.

Composition analysis was performed using high-frequency inductively-coupled plasma (ICP) emission spectrometry. For analyzing the single crystal phosphors having an extremely low Ce concentration, ICP mass spectrometry (ICP-MS) was used in combination.

For evaluating CIE chromaticity coordinates, CIE **1931** color-matching functions were used to obtain the CIE chromaticity coordinates of the emission spectrum of the single crystal phosphors when the peak wavelength of the excitation light is **450** nm.

The internal quantum efficiency was evaluated using a quantum efficiency measurement system having an integrating hemisphere unit. The following is a specific method of measuring the internal quantum efficiency of the single crystal phosphor.

Firstly, excitation light is irradiated onto barium sulfate powder provided as a standard sample and placed in the integrating hemisphere unit, and the excitation light spectrum is measured. Next, excitation light is irradiated onto the single crystal phosphor placed on the barium sulfate in the integrating hemisphere unit, and the excitation light reflection spectrum and the fluorescence spectrum are measured. Next, in the integrating hemisphere unit, the diffusely-reflected excitation light is irradiated onto the single crystal phosphor placed on the barium sulfate and the re-excitation fluorescence spectrum is measured.

Then, a difference between the number of photons obtained from the fluorescence spectrum and the number of photons obtained from the re-excitation fluorescence spectrum is divided by a difference between the number of photons obtained from the excitation light spectrum and the number of photons obtained from the excitation light reflection spectrum. The internal quantum efficiency is thereby obtained.

Table **1** below shows the results of evaluating the wavelength of fluorescence and the CIE chromaticity. In Table **1,** the samples No.**1** to No.**33** are samples of the single crystal phosphors in the present embodiment and the samples No.**34** to No.**36** are samples of Ce-activated YAG-based polycrystalline phosphor powder as Comparative Examples. Table **1** shows the values of a, b and c in the compositional formula of the single crystal phosphor in the present embodiment, the peak wavelengths λp (nm) of fluorescence when the peak wavelength of the excitation light is **440** nm, **450** nm and **460** nm, and the CIE chromaticity coordinates (x, y) when the peak wavelength of the excitation light is **440** nm, **450** nm and **460** nm.

**[Table 1]**

| Sample No. | a | b | c | λp [nm] at 440 nm | λp [nm] at 450 nm | λp [nm] at 460 nm | CIE chromaticity at 440 nm | | CIE chromaticity at 450 nm | | CIE chromaticity at 460 nm | |
|---|---|---|---|---|---|---|---|---|---|---|---|---|
| | | | | | | | x-coordinate | y-coordinate | x-coordinate | y-coordinate | x-coordinate | y-coordinate |
| 1 | 0.2909 | 0.0017 | 0.022 | 538 | 536 | 538 | 0.409 | 0.568 | 0.411 | 0.567 | 0.412 | 0.566 |
| 2 | 0.9994 | 0.0006 | 0.023 | 514 | 515 | 514 | 0.329 | 0.600 | 0.329 | 0.600 | 0.330 | 0.599 |
| 3 | 0 | 0.0013 | 0.000 | 533 | 539 | 534 | 0.415 | 0.562 | 0.415 | 0.562 | 0.415 | 0.562 |
| 4 | 0 | 0.0047 | 0.005 | 540 | 540 | 539 | 0.421 | 0.559 | 0.421 | 0.559 | 0.422 | 0.559 |
| 5 | 0 | 0.0067 | -0.010 | 545 | 546 | 545 | 0.434 | 0.550 | 0.434 | 0.551 | 0.434 | 0.551 |
| 6 | 0 | 0.0014 | 0.175 | 540 | 541 | 542 | 0.424 | 0.558 | 0.425 | 0.557 | 0.424 | 0.557 |
| 7 | 0 | 0.0014 | 0.228 | 541 | 543 | 542 | 0.424 | 0.558 | 0.424 | 0.558 | 0.424 | 0.557 |
| 8 | 0 | 0.0014 | 0.167 | 540 | 543 | 541 | 0.426 | 0.557 | 0.426 | 0.557 | 0.425 | 0.556 |
| 9 | 0 | 0.0002 | 0.137 | 531 | 531 | 531 | 0.405 | 0.566 | 0.405 | 0.564 | 0.403 | 0.559 |
| 10 | 0 | 0.0002 | 0.190 | 531 | 530 | 536 | 0.405 | 0.564 | 0.405 | 0.564 | 0.403 | 0.559 |
| 11 | 0 | 0.0005 | 0.054 | 530 | 533 | 529 | 0.412 | 0.563 | 0.412 | 0.563 | 0.411 | 0.561 |
| 12 | 0 | 0.0010 | 0.128 | 540 | 537 | 538 | 0.420 | 0.560 | 0.420 | 0.560 | 0.419 | 0.559 |
| 13 | 0.0222 | 0.0013 | 0.021 | 530 | 531 | 531 | 0.407 | 0.567 | 0.408 | 0.566 | 0.408 | 0.564 |
| 14 | 0.0905 | 0.0013 | -0.016 | 533 | 536 | 537 | 0.415 | 0.562 | 0.415 | 0.562 | 0.415 | 0.561 |
| 15 | 0.1133 | 0.0013 | 0.002 | 533 | 531 | 531 | 0.405 | 0.567 | 0.406 | 0.567 | 0.406 | 0.564 |
| 16 | 0.1436 | 0.0014 | -0.006 | 530 | 530 | 531 | 0.406 | 0.568 | 0.407 | 0.567 | 0.408 | 0.565 |
| 17 | 0.2735 | 0.0006 | 0.036 | 529 | 528 | 528 | 0.395 | 0.574 | 0.397 | 0.572 | 0.399 | 0.571 |
| 18 | 0.5301 | 0.0009 | 0.047 | 528 | 528 | 530 | 0.381 | 0.582 | 0.384 | 0.581 | 0.386 | 0.579 |
| 19 | 0.2324 | 0.0002 | 0.140 | 525 | 525 | 528 | 0.388 | 0.572 | 0.390 | 0.571 | 0.390 | 0.565 |
| 20 | 0.2239 | 0.0002 | 0.170 | 524 | 529 | 525 | 0.387 | 0.570 | 0.389 | 0.569 | 0.390 | 0.566 |
| 21 | 0.2183 | 0.0002 | 0.161 | 528 | 526 | 527 | 0.387 | 0.571 | 0.389 | 0.569 | 0.391 | 0.566 |
| 22 | 0.1955 | 0.0003 | 0.315 | 528 | 531 | 530 | 0.394 | 0.572 | 0.396 | 0.571 | 0.396 | 0.567 |
| 23 | 0.1892 | 0.0008 | 0.112 | 531 | 532 | 533 | 0.405 | 0.569 | 0.406 | 0.568 | 0.407 | 0.566 |
| 24 | 0.2298 | 0.0004 | 0.158 | 530 | 529 | 533 | 0.399 | 0.572 | 0.401 | 0.571 | 0.402 | 0.570 |
| 25 | 0.2099 | 0.0006 | 0.216 | 534 | 531 | 531 | 0.405 | 0.570 | 0.406 | 0.569 | 0.407 | 0.568 |
| 26 | 0.1886 | 0.0011 | 0.251 | 537 | 536 | 538 | 0.412 | 0.566 | 0.413 | 0.565 | 0.414 | 0.565 |
| 27 | 0.2932 | 0.0006 | 0.152 | 529 | 531 | 532 | 0.400 | 0.573 | 0.402 | 0.571 | 0.403 | 0.570 |
| 28 | 0.2821 | 0.0009 | 0.158 | 533 | 533 | 534 | 0.404 | 0.571 | 0.406 | 0.570 | 0.407 | 0.569 |
| 29 | 0.2597 | 0.0014 | 0.168 | 543 | 539 | 539 | 0.412 | 0.567 | 0.413 | 0.566 | 0.415 | 0.565 |
| 30 | 0.3528 | 0.0009 | 0.177 | 533 | 531 | 531 | 0.399 | 0.574 | 0.400 | 0.573 | 0.402 | 0.571 |
| 31 | 0.3357 | 0.0012 | 0.145 | 533 | 533 | 535 | 0.404 | 0.572 | 0.405 | 0.571 | 0.407 | 0.569 |
| 32 | 0.3109 | 0.0021 | 0.130 | 543 | 543 | 543 | 0.415 | 0.565 | 0.417 | 0.564 | 0.418 | 0.563 |
| 33 | 0.3357 | 0.0012 | 0.145 | 527 | 527 | 529 | 0.385 | 0.573 | 0.387 | 0.571 | 0.390 | 0_{.}570 |
| 34 | | | | 522 | 520 | 524 | 0.344 | 0.585 | 0.344 | 0.585 | 0.347 | 0.584 |
| 35 | | | | 546 | 545 | 547 | 0.403 | 0.560 | 0.404 | 0.559 | 0.407 | 0.558 |
| 36 | | | | 543 | 543 | 544 | 0.419 | 0.555 | 0.418 | 0.557 | 0.419 | 0.556 |

As shown in Table **1,** the values of a, b and c in the compositional formula (Y_{**1**-a-b}LuₐCe_{b})_{**3**+c}Al_{**5**-c}O**₁₂** expressing the single crystal phosphors used for the evaluation are respectively in the ranges of **0≤**a**≤0.9994, 0.0002≤**b**≤0.0067, -0.016≤**c**≤0.315.**

The value of a in the compositional formula of the single crystal phosphors containing Lu is in a range of **0.0222≤**a**≤0.9994,** and the value of a in the compositional formula of the single crystal phosphors not containing Lu is a=**0**.

The single crystal phosphors containing Lu, which produce fluorescence of a color closer to green than that of the single crystal phosphors not containing Lu, can create white light having high color rendering properties when used with a blue light source in combination with a reddish phosphor. On the other hand, the single crystal phosphors not containing Lu can create white light with a high color temperature when used with a blue light source without a combination with a reddish phosphor.

The single crystal phosphors containing Lu generally have better temperature characteristics than the single crystal phosphors not containing Lu. However, since Lu is expensive, the manufacturing cost increases when adding Lu to the single crystal phosphor.

In addition, based on Table **1,** when the values of a and b in the compositional formula of the single crystal phosphors used for the evaluation are respectively in the ranges of **0≤**a**≤0.9994** and **0.0002≤**b**≤0.0067,** the x and y values of the CIE chromaticity coordinates for fluorescence are respectively in the ranges of **0.329≤**x**≤0.434** and **0.551≤**y**≤0.600** when the peak wavelength of the excitation light is **450** nm.

**FIG.1** is a graph showing composition distribution in the single crystal phosphor in the first embodiment used for the evaluation. In **FIG.1****,** the horizontal axis indicates the value of a (Lu concentration) in the compositional formula of the single crystal phosphor and the vertical axis indicates the value of b (Ce concentration) in the compositional formula.

**FIG.2** is a graph showing CIE (xy) chromaticity distribution of the single crystal phosphor in the first embodiment used for the evaluation, In **FIG.2** which shows the CIE chromaticity when the peak wavelength of the excitation light is **450** nm, the horizontal axis indicates the x-coordinate and the vertical axis indicates the y-coordinate.

The straight line y=**-0.4377**x+**0.7444** in **FIG.2** is an approximate straight line of the CIE chromaticity coordinates at the peak wavelength of **450** nm and is derived by the least-squares method. Then, a dotted line above the approximate straight line is a line represented by y=-**0.4377** x+**0.7504** and a dotted line below is a line represented by y=**0.4377**x+**0.7384**.

As shown in **FIG.2****,** in the single crystal phosphor which has a composition represented by a compositional formula (Y_{**1**-a-b}LuₐCe_{b})_{**3**+c}Al_{**5**-c}O**₁₂** (where **0**≤a≤**0.9994, 0.0002≤**b**≤0.0067**, **-0.016≤**c**≤0.315**), the CIE xy chromaticity coordinates of emission spectrum satisfy the relation -**0.4377**x + **0.7384** ≤ y ≤ **-0.4377** x + **0.7504** when the peak wavelength of the excitation light is **450** nm and the temperature is **25**°C.

Table **2** below shows the results of evaluating the internal quantum efficiency. Table **2** shows the values of a, b and c in the compositional formula of the single crystal phosphors in the present embodiment and internal quantum efficiency (ηᵢₙₜ) at **25**°C when the peak wavelength of the excitation light is **440** nm, **450** nm and **460** nm.

**[Table 2]**

| Sample No. | a | b | c | Internal c quantum efficiency (ηᵢₙₜ) | | |
|---|---|---|---|---|---|---|
| | | | | 440 nm | 450 nm | 460 nm |
| 1 | 0.2909 | 0.0017 | 0.022 | 0.98 | 0.98 | 0.97 |
| 2 | 0.9994 | 0.0006 | 0.023 | 1.00 | 0.99 | 0.97 |
| 3 | 0 | 0.0013 | 0.000 | 1.00 | 0.99 | 0.96 |
| 4 | 0 | 0.0047 | 0.005 | 0.99 | 0.98 | 0.98 |
| 5 | 0 | 0.0067 | -0.010 | 1.00 | 1.00 | 1.00 |
| 6 | 0 | 0.0014 | 0.175 | 0.99 | 0.98 | 0.99 |
| 7 | 0 | 0.0014 | 0.228 | 1.00 | 0.98 | 0.99 |
| 8 | 0 | 0.0014 | 0.167 | 0.99 | 0.97 | 0.98 |
| 9 | 0 | 0.0002 | 0.137 | 0.95 | 0.96 | 0.95 |
| 10 | 0 | 0.0002 | 0.190 | 0.96 | 1.00 | 0.96 |
| 11 | 0 | 0.0005 | 0.054 | 0.95 | 0.99 | 0.94 |
| 12 | 0 | 0.0010 | 0.128 | 0.97 | 0.96 | 0.96 |
| 13 | 0.0222 | 0.0013 | 0.021 | 1.00 | 0.99 | 0.96 |
| 14 | 0.0905 | 0.0013 | -0.016 | 1.00 | 0.96 | 0.96 |
| 15 | 0.1133 | 0.0013 | 0.002 | 0.98 | 0.97 | 0.95 |
| 16 | 0.1436 | 0.0014 | -0.006 | 0.99 | 0.96 | 0.98 |
| 17 | 0.2735 | 0.0006 | 0.036 | 0.94 | 0.98 | 0.96 |
| 18 | 0.5301 | 0.0009 | 0.047 | 0.97 | 0.96 | 0.96 |
| 19 | 0.2324 | 0.0002 | 0.140 | 0.91 | 0.91 | 0.95 |
| 20 | 0.2239 | 0.0002 | 0.170 | 0.93 | 0.98 | 0.95 |
| 21 | 0.2183 | 0.0002 | 0.161 | 0.99 | 0.96 | 0.97 |
| 22 | 0.1955 | 0.0003 | 0.315 | 0.93 | 0.94 | 0.94 |
| 23 | 0.1892 | 0.0008 | 0.112 | 0.96 | 0.96 | 0.96 |
| 24 | 0.2298 | 0.0004 | 0.158 | 0.93 | 0.96 | 0.96 |
| 25 | 0.2099 | 0.0006 | 0.216 | 0.98 | 0.94 | 0.96 |
| 26 | 0.1886 | 0.0011 | 0.251 | 0.98 | 1.00 | 0.97 |
| 27 | 0.2932 | 0.0006 | 0.152 | 0.96 | 0.95 | 0.96 |
| 28 | 0.2821 | 0.0009 | 0.158 | 0.98 | 0.99 | 0.99 |
| 29 | 0.2597 | 0.0014 | 0.168 | 0.99 | 0.99 | 0.99 |
| 30 | 0.3528 | 0.0009 | 0.177 | 0.98 | 0.95 | 0.96 |
| 31 | 0.3357 | 0.0012 | 0.145 | 0.99 | 0.98 | 0.95 |
| 32 | 0.3109 | 0.0021 | 0.130 | 0.98 | 0.98 | 0.96 |
| 33 | 0.3357 | 0.0012 | 0.145 | 0.94 | 0.94 | 0.94 |

Based on Table **2,** the single crystal phosphors in the present embodiment have high internal quantum efficiency. All of the evaluated single crystal phosphor samples have an internal quantum efficiency of, e.g., not less than **0.91** when the temperature is **25**°C and the peak wavelength of the excitation light is **450** nm.

The shapes of the evaluated single crystal phosphor samples are as follows: the samples No.**15** to No.**19** were **0.3** mm-thick circular flat plates having a diameter of **10** mm; the sample No.**33** was powder; and the other samples were **0.3** mm-thick square flat plates of **10** mm in each side. In addition, all samples except the powder sample had mirror-polished surfaces on both sides.

The peak wavelength λp (nm) of fluorescence, the CIE chromaticity coordinates (x, y) and the measured values of internal quantum efficiency are hardly affected by the shapes of the samples.

### [Comparison with Polycrystalline phosphor]

A relation of the Ce concentration with emission color is largely different between the Ce-activated YAG-based single crystal phosphor and the YAG-based polycrystalline phosphor powder. It is set forth in, e.g., PTL 1 (JP-A-**2010-24278**) that polycrystalline phosphor powder having a composition represented by a compositional formula (Y_{**1**-z}Ce_{z})**₃**Al**₅**O**₁₂** emits light with a specific chromaticity of **(0.41, 0.56)** in a Ce concentration range of **0.003**≤z≤**0.2.** On the other hand, the single crystal phosphor in the present embodiment has a chromaticity varying depending on the Ce concentration and its composition is, e.g., (Y_{**1**-z}Ce_{z})**₃**Al**₅**O**₁₂** (z=**0.0005**) to emit light with the same chromaticity **(0.41, 0.56)** as the polycrystalline phosphor powder of PTL 1.

Meanwhile, it is set forth in PTL 2 **(**JP-B-**3503139)** that polycrystalline phosphor powder having a composition represented by a compositional formula (Y_{**1**-a-b}LuₐCe_{b})**₃**Al**₅**O**₁₂** emits light with a chromaticity of **(0.339, 0.579)** when a=**0.99** and b=**0.01** and emits light with a chromaticity of **(0.377, 0.570)** when a=**0.495** and b=**0.01**. The concentration of Ce contained in this polycrystalline phosphor powder is also several orders of magnitude higher than the concentration of Ce contained in the single crystal phosphor in the present embodiment.

As such, the concentration of Ce added to the single crystal phosphor to emit light with a desired color is extremely lower than the polycrystalline phosphor and it is possible to reduce the amount of expensive Ce to be used.

### [Second embodiment]

The second embodiment is a light-emitting device having the single crystal phosphor of the first embodiment.

### [Configuration of Light-emitting device]

**FIG.3A** is a vertical cross-sectional view showing a light-emitting device **10** in the second embodiment. **FIG.3B** is an enlarged view showing a light-emitting element **100** and the periphery thereof in the light-emitting device **10.**

The light-emitting device **10** has a substrate **11** having wirings **12**a and **12**b on the surface thereof, the light-emitting element **100** mounted on the substrate **11,** a single crystal phosphor **13** provided on the light-emitting element **100,** an annular sidewall **14** surrounding the light-emitting element **100,** and a sealing material **15** for sealing the light-emitting element **100** and the single crystal phosphor **13.**

The substrate **11** is formed of, e.g., ceramics such as Al₂O₃. The wirings **12**a and **12**b are pattern-formed on the surface of the substrate **11.** The wirings **12**a and **12**b are formed of, e.g., a metal such as tungsten.

The light-emitting element **100** is a flip-chip type LED chip and emits bluish light. The peak emission wavelength of the light-emitting element **100** is preferably in a range of **430** to **480** nm from the viewpoint of internal quantum efficiency of the light-emitting element **100,** and is more preferably in a range of **440** to **470** nm from the viewpoint of internal quantum efficiency of the single crystal phosphor **13.**

In the light-emitting element **100,** an n-type semiconductor layer **102** formed of, e.g., GaN doped with an n-type impurity, a light-emitting layer **103** and a p-type semiconductor layer **104** formed of, e.g., GaN doped with a p-type impurity are laminated in this order on a first main surface **101**a of an element substrate **101** formed of sapphire, etc. An n-side electrode **105**a is formed on the exposed portion of the n-type semiconductor layer **102** and a p-side electrode **105**b is formed on the surface of the p-type semiconductor layer **104.**

Carriers are injected from the n-type semiconductor layer **102** and the p-type semiconductor layer **104** into the light-emitting layer **103** which thereby emits bluish light. The light emitted from the light-emitting layer **103** is transmitted through the n-type semiconductor layer **102** and the element substrate **101** and exits from a second main surface **101**b of the element substrate **101.** That is, the second main surface **101**b of the element substrate **101** is a light-emitting surface of the light-emitting element **100.**

The single crystal phosphor **13** is arranged on the second main surface **101**b of the element substrate **101** so as to cover the entire second main surface **101**b.

The single crystal phosphor **13** is a plate-shaped single crystal phosphor formed of the single crystal phosphor in the first embodiment. The single crystal phosphor **13** is formed of one single crystal and thus does not include grain boundaries. The single crystal phosphor **13** has an area equal to or greater than the second main surface **101**b. The single crystal phosphor **13** absorbs light emitted by the light-emitting element **100** and produces yellowish fluorescence.

The single crystal phosphor **13** is placed directly on the second main surface **101**b of the element substrate **101** without interposition of any members such that a first surface **13**a, which is a surface of the single crystal phosphor **13** on the element substrate **101** side, is in contact with the second main surface **101**b of the element substrate **101.** The single crystal phosphor **13** and the element substrate **101** are bonded by, e.g., an intermolecular force.

The n-side electrode **105**a and the p-side electrode **105**b of the light-emitting element **100** are electrically connected respectively to the wirings **12**a and **12**b via conductive bumps **106.**

The sidewall **14** is formed of a resin such as silicone-based resin or epoxy-based resin and may contain light reflective particles of titanium dioxide, etc.

The sealing material **15** is formed of, e.g., a translucent resin such as silicone-based resin or epoxy-based resin. The sealing material **15** may contain particles of reddish phosphor which absorbs the light emitted from the light-emitting element **100** and emits reddish fluorescence. From the viewpoint of brightness and color rendering properties, the peak emission wavelength of the reddish phosphor is preferably in a range of **600** to **660** nm, more preferably, in a range of **635** to **655** nm. Its wavelength when too small is close to the emission wavelength of the single crystal phosphor **13** and causes a decrease in color rendering properties. On the other hand, too large wavelength increases the influence on a decrease in luminous sensitivity.

### [Operation of Light-emitting device]

When power is distributed to the light-emitting element **100,** electrons are injected into the light-emitting layer **103** through the wiring **12**a, the n-side electrode **105**a and the n-type semiconductor layer **102** while holes are injected into the light-emitting layer **103** through the wiring **12**b, the p-side electrode **105**b and the p-type semiconductor layer **104,** resulting in that the light-emitting layer **103** emits light.

Bluish light emitted from the light-emitting layer **103** is transmitted through the n-type semiconductor layer **102** and the element substrate **101,** exits from the second main surface **101**b of the element substrate **101** and is incident on the first surface **13**a of the single crystal phosphor **13.**

The single crystal phosphor **13** absorbs a portion of bluish light emitted from the light-emitting element **100** and produces yellowish fluorescence.

A portion of the bluish light emitted from the light-emitting element **100** and travelling toward the single crystal phosphor **13** is absorbed by the single crystal phosphor **13,** is wavelength-converted and exits as yellowish light from a second surface **13**b of the single crystal phosphor **13.** Meanwhile, another portion the bluish light emitted from the light-emitting element **100** and travelling toward the single crystal phosphor **13** exits from the second surface **13**b without being absorbed by the single crystal phosphor **13.** Since blue and yellow are complementary colors, the light-emitting device **10** emits white light as a mixture of blue light and yellow light.

Meanwhile, in case that the sealing material **15** contains a reddish phosphor, the reddish phosphor absorbs a portion of the bluish light emitted from the light-emitting element **100** and produces reddish fluorescence. In this case, the light-emitting device **10** emits white light as a mixture of blue light, yellow light and red light. Mixing the red light improves color rendering properties of white light.

**FIG.4** is a chromaticity diagram which plots the CIE chromaticity of light (fluorescence) emitted from the single crystal phosphor **13** alone and the CIE chromaticity of a mixture light of light emitted from the light-emitting element **100** and light emitted from the single crystal phosphor **13.** Eight quadrilateral boxes arranged in a row in **FIG.4** are chromaticity ranges at color temperatures of **2700** to **6500**K defined by the chromaticity standard (ANSI C78.377).

A curved line L**1** in **FIG.4** represents a relation between the Ce concentration and emission chromaticity of the single crystal phosphor **13.** Open diamond markers "◊" on the curved line L**1** are the actual measured values of emission chromaticity of the single crystal phosphor **13** when the value of b (Ce concentration) in the compositional formula of the single crystal phosphor **13** is **0.0002, 0.0005, 0.0010** and **0.0014** in order from left to right.

A curved line **L2** in **FIG.4** represents a relation between the Ce concentration in the single crystal phosphor **13** and chromaticity of a mixture light yielded by a combination of the light-emitting element **100** and the single crystal phosphor **13.** Filled circle markers "●" on the curved line L**2** are the actual measured values of the chromaticity of the mixture light yielded by a combination of the light-emitting element **100** and the single crystal phosphor **13** when the value of b in the compositional formula of the single crystal phosphor **13** is **0.0002, 0.0005, 0.0010** and **0.0014** in order from bottom to top.

These actual measured values were obtained by measuring the fluorescence spectrum of the single crystal phosphor **13** and the synthetic spectrum of light from the light-emitting element **100** with fluorescence from the single crystal phosphor **13** when the value of a is fixed to **0** and the value of b is varied in the compositional formula (Y_{**1**-a-b}LuₐCe_{b})_{**3**+c}Al_{**5**-c}O**₁₂** of the single crystal phosphor **13.**

The emission wavelength of the light-emitting element **100** used for this measurement is **450** nm. The single crystal phosphor **13** is a plate-shaped single crystal phosphor having a thickness of **0.3** mm.

As indicated by the curved lines L**1** and L**2**, due to Ce which functions as an activator for the single crystal phosphor **13,** the chromaticity of the mixture light yielded by a combination of the light-emitting element **100** and the single crystal phosphor **13** becomes closer to the chromaticity of fluorescence from the single crystal phosphor **13** alone as the Ce concentration in the single crystal phosphor **13** becomes higher (the value of b becomes larger). The chromaticity of the mixture light when b=**0** is equal to the emission chromaticity of the light-emitting element **100** alone since the single crystal phosphor **13** does not produce fluorescence.

Here, the lower limit of the thickness of the plate-shaped single crystal phosphor **13** is **0.15** mm. The thickness of the single crystal phosphor **13** is set to not less than **0.15** mm from the viewpoint of mechanical strength.

Even if the value of a in the compositional formula of the single crystal phosphor **13** is changed, the chromaticity in the direction of the curved line L**2** hardly changes since Lu does not function as an activator. Likewise, even if the emission wavelength of the light-emitting element **100** is changed, the chromaticity in the direction of the curved line L**2** hardly changes.

FIG5 is a chromaticity diagram which plots the CIE chromaticity of a mixture light yielded by a combination of the light-emitting element **100,** the single crystal phosphor **13** and a reddish phosphor.

The curved line L**2** in **FIG.5** is equal to the curved line **L2** in **FIG.4****.** The point R indicates a chromaticity **(0.654, 0.345)** of fluorescence from the reddish phosphor. In addition, eight quadrilateral boxes arranged in a row are chromaticity ranges at color temperatures of **2700** to **6500K** defined by the chromaticity standard (ANSI C**78.377**).

A straight line L**3** is a line passing through the point R and the lower edge of the box for the color temperature of **2700**K, and a straight line L**4** is a line passing through the point R and the upper edge of the box at the color temperature for **6500**K. Then, the point Y**1** is an intersection of the curved line L**2** with the straight line L**3**, and the point Y**2** is an intersection of the curved line L**2** with the straight line L**4**.

Firstly, the Ce concentration and the thickness of the single crystal phosphor are adjusted so that the chromaticity coordinates of the emission light when combining the light-emitting element **100** and the single crystal phosphor **13** are located between the point Y**1** and the point Y**2** on the straight line L**2** in **FIG5****.** Next, the amount of the reddish phosphor (the concentration in the sealing material **15** when dispersed in the sealing material **15)** is adjusted, thereby producing white light with a color temperature of **2700** to **6500**K**.**

At this time, since the single crystal phosphor **13** and the reddish phosphor absorb fluorescence each other, the relation between the chromaticity R and the combined chromaticity of the light-emitting element **100** and the single crystal phosphor **13** does not linearly vary with respect to the adjusted amount of the reddish phosphor, but the above-mentioned method allows white color roughly at an intended color temperature to be created.

Even if the value of a in the compositional formula of the single crystal phosphor **13** is changed, the chromaticity in the direction of the curved line L**2** hardly changes since Lu does not function as an activator. Therefore, when the single crystal phosphor **13** contains Lu, the amount of the reddish phosphor used in combination with the single crystal phosphor **13** and the light-emitting element **100** is adjusted in accordance with the Lu concentration to allow white light with a color temperature of **2700** to **6500**K to be created.

In addition, even if the emission wavelength of the light-emitting element **100** or the emission wavelength of the reddish phosphor is changed, the chromaticity in the direction of the curved line L**2** hardly changes in the same manner. And, at least when the peak emission wavelength of the light-emitting element **100** is in a range of **430** to **480** nm and the peak emission wavelength of the reddish phosphor is in a range of **600** to **660** nm, adjusting the amount of the reddish phosphor allows white light with a color temperature of **2700** to **6500**K to be created in the same manner.

The following simulation was performed to demonstrate that light emitted from the light-emitting device **10** in the second embodiment is excellent in color rendering properties. Here, color rendering properties when the light-emitting device **10** emits light with a color temperature of **3000**K will be described as an example.

**FIG.6** shows emission spectra of the light-emitting element **100,** the single crystal phosphor **13** and the reddish phosphor which were used for simulation (these spectra are referred to as "fundamental spectra").

The peak wavelengths of fundamental spectra of the light-emitting element **100,** the single crystal phosphor **13** and the reddish phosphor are about **450** nm (blue), **535** nm (yellow) and **640** nm (red). The fundamental spectrum of the single crystal phosphor **13** is an emission spectrum of the single crystal phosphor **13** having a composition represented by (Y_{**1**-a-b}LuₐCe_{b})_{**3**+c}Al_{**5**-c}O**₁₂** (a=**0**, b=**0.0010,** c=**0.128)**.

Firstly, given that the emission spectrum of the light-emitting device **10** can approximate to the synthetic emission spectrum of the light-emitting element **100,** the single crystal phosphor **13** and the reddish phosphor, the fundamental spectra of the light-emitting element **100,** the single crystal phosphor **13** and the reddish phosphor are fitted to a spectrum having a chromaticity corresponding to the color temperature of **3000**K by the least-squares method, and a linear coupling coefficient of each fundamental spectrum was determined.

Then, an average color rendering index Ra is calculated from the synthetic spectrum obtained by the data fitting. This provides the average color rendering index Ra when the light-emitting device **10** emitting light with a color temperature of **3000K** is formed using the light-emitting element **100,** the single crystal phosphor **13** and the reddish phosphor of which emission spectra are the fundamental spectra.

Following this, the above-mentioned simulation was repeated while shifting the wavelengths of the fundamental spectra of the light-emitting element **100** and the single crystal phosphor **13** (the fundamental spectrum of the reddish phosphor is fixed) to obtained the average color rendering index Ra at various wavelengths of the light-emitting element **100** and the single crystal phosphor **13.** Here, the wavelength of the light-emitting element **100** was varied from the wavelength of the fundamental spectrum in increments of **5** nm in the range of **-20** to +**30** nm. Meanwhile, the wavelength of the single crystal phosphor **13** was varied from the wavelength of the fundamental spectrum in increments of **5** nm in the range of **-45** to **+45** nm. The results are shown in Table **3** below.

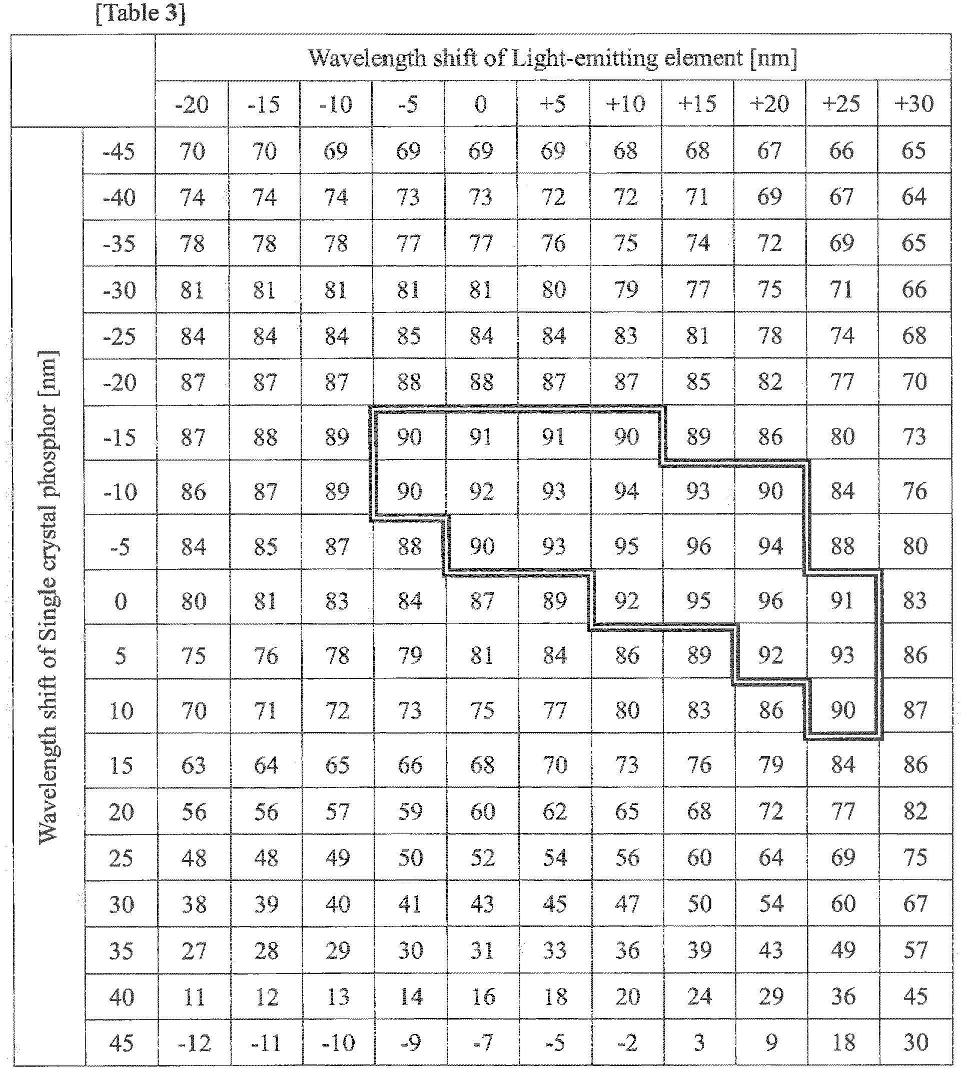

Table **3** shows that a high average color rendering index Ra of not less than **90** or even not less than **95** can be obtained by suitably adjusting the wavelengths of the light-emitting element **100** and the single crystal phosphor **13.**

### [Third embodiment]

The third embodiment is different from the second embodiment in that the light-emitting element is a face-up type LED chip. The explanation for the same features as the first embodiment will be omitted or simplified.

### [Configuration of Light-emitting device]

**FIG.7A** is a vertical cross-sectional view showing a light-emitting device **20** in the third embodiment. **FIG.7B** is an enlarged view showing a light-emitting element **200** and the periphery thereof in the light-emitting device **20.** **FIG.7C** is a top view showing the light-emitting element **200.**

The light-emitting device **20** has the substrate **11** having the wirings **12**a and **12**b on the surface thereof, the light-emitting element **200** mounted on the substrate **11,** a single crystal phosphor **21** provided on the light-emitting element **200,** the annular sidewall **14** surrounding the light-emitting element **200,** and the sealing material **15** for sealing the light-emitting element **200** and the single crystal phosphor **21.**

The light-emitting element **100** is a face-up type LED chip and emits bluish light having an intensity peak at a wavelength of **380** to **490** nm. In the light-emitting element **200,** an n-type semiconductor layer **202** formed of, e.g., GaN doped with an n-type impurity, a light-emitting layer **203,** a p-type semiconductor layer **204** formed of, e.g., GaN doped with a p-type impurity and a transparent electrode **207** formed of ITO (Indium Tin Oxide), etc., are laminated in this order on an element substrate **201** formed of sapphire, etc. An n-side electrode **205**a is formed on the exposed portion of the n-type semiconductor layer **102** and a p-side electrode **205**b is formed on an upper surface **207**b of the transparent electrode **207.**

Carriers are injected from the n-type semiconductor layer **202** and the p-type semiconductor layer **204** into the light-emitting layer **203** which thereby emits bluish light. The light emitted from the light-emitting layer **203** is transmitted through the p-type semiconductor layer **204** and the transparent electrode **207** and exits from the upper surface **207**b of the transparent electrode **207.** That is, the upper surface **207**b of the transparent electrode **207** is a light-emitting surface of the light-emitting element **200.**

The substantially square-shaped single crystal phosphor **21** having cutouts at portions corresponding to the installation positions of the n-side electrode **205**a and the p-side electrode **205**b is arranged on the upper surface **207**b of the transparent electrode **207.**

The single crystal phosphor **21** is a plate-shaped single crystal phosphor formed of the single crystal phosphor in the first embodiment. The single crystal phosphor **21** is formed of one single crystal and thus does not include grain boundaries.

The single crystal phosphor **21** is placed directly on the upper surface **207**b of the transparent electrode **207** without interposition of any members such that a first surface **21**a**,** which is a surface of the single crystal phosphor **21** on the transparent electrode **207** side, is in contact with the upper surface **207**b of the transparent electrode **207.**

The n-side electrode **205**a and the p-side electrode **205**b of the light-emitting element **200** are electrically connected respectively to the wirings **12**a and **12**b via bonding wires **206.**

### [Operation of Light-emitting device]

When power is distributed to the light-emitting element **200,** electrons are injected into the light-emitting layer **203** through the wiring **12**a, the n-side electrode **205**a and the n-type semiconductor layer **202** while holes are injected into the light-emitting layer **203** through the wiring **12**b, the p-side electrode **205**b, the transparent electrode **207** and the p-type semiconductor layer **204,** resulting in that the light-emitting layer **203** emits light.

Bluish light emitted from the light-emitting layer **203** is transmitted through the p-type semiconductor layer **204** and the transparent electrode **207,** exits from the upper surface **207**b of the transparent electrode **207** and is incident on the first surface **21**a of the single crystal phosphor **21.**

The single crystal phosphor **21** absorbs a portion of bluish light emitted from the light-emitting element **200** and produces yellowish fluorescence.

A portion of the bluish light emitted from the light-emitting element **200** and travelling toward the single crystal phosphor **21** is absorbed by the single crystal phosphor **21,** is wavelength-converted and exits as yellowish light from a second surface **21**b of the single crystal phosphor **21.** Meanwhile, another portion the bluish light emitted from the light-emitting element **200** and travelling toward the single crystal phosphor **21** exits from the second surface **21b** without being absorbed by the single crystal phosphor **21.** Since blue and yellow are complementary colors, the light-emitting device **20** emits white light as a mixture of blue light and yellow light.

Meanwhile, in case that the sealing material **15** contains a reddish phosphor, the reddish phosphor absorbs a portion of the bluish light emitted from the light-emitting element **200** and produces reddish fluorescence. In this case, the light-emitting device **20** emits white light as a mixture of blue light, yellow light and red light. Mixing the red light improves color rendering properties of white light.

### [Fourth embodiment]

The fourth embodiment is different from the second embodiment in the installation position of the single crystal phosphor. The explanation for the same features as the second embodiment will be omitted or simplified.

**FIG.8** is a vertical cross-sectional view showing a light-emitting device **30** in the fourth embodiment. The light-emitting device **30** has the substrate **11** having the wirings **12**a and **12**b on the surface thereof, the light-emitting element **100** mounted on the substrate **11,** a single crystal phosphor **31** provided above the light-emitting element **100,** the annular sidewall **14** surrounding the light-emitting element **100,** and the sealing material **15** for sealing the light-emitting element **100** and the single crystal phosphor **21.**

The single crystal phosphor **31** is a plate-shaped single crystal phosphor formed of the single crystal phosphor in the first embodiment. The single crystal phosphor **31** is formed of one single crystal and thus does not include grain boundaries.

The single crystal phosphor **31** is placed on an upper surface **14**b of the sidewall **14** so as to close an opening of the annular sidewall **14.** The light exiting from the second main surface **101**b of the element substrate **101** of the light-emitting element **100** is incident on a first surface **31**a of the single crystal phosphor **31.**

The single crystal phosphor **31** absorbs a portion of bluish light emitted from the light-emitting element **100** and produces yellowish fluorescence.

A portion of the bluish light emitted from the light-emitting element **100** and travelling toward the single crystal phosphor **31** is absorbed by the single crystal phosphor **31,** is wavelength-converted and exits as yellowish light from a second surface **31**b of the single crystal phosphor **31.** Meanwhile, another portion the bluish light emitted from the light-emitting element **100** and travelling toward the single crystal phosphor **31** exits from the second surface **31**b without being absorbed by the single crystal phosphor **31.** Since blue and yellow are complementary colors, the light-emitting device **30** emits white light as a mixture of blue light and yellow light.

Meanwhile, in case that the sealing material **15** contains a reddish phosphor, the reddish phosphor absorbs a portion of the bluish light emitted from the light-emitting element **100** and produces reddish fluorescence. In this case, the light-emitting device **30** emits white light as a mixture of blue light, yellow light and red light. Mixing the red light improves color rendering properties of white light. In case that the light-emitting device **30** does not include the reddish phosphor, the light-emitting device **30** may not have the sealing material **15.**

### [Fifth embodiment]

Next, the fifth embodiment of the invention will be described in reference to **FIG.9. FIG.9** is a vertical cross-sectional view showing a light-emitting device **40** in the fifth embodiment. As shown in **FIG.9**, the fifth embodiment is different from the second embodiment in the form and arrangement of the phosphor. Constituent elements of the light-emitting device **40** having the same functions and structures as those in the second embodiment are denoted by the same reference numerals and the explanation thereof will be omitted.

As shown in **FIG.9****,** the light-emitting device **40** has the light-emitting element **100** such as LED, the substrate **11** supporting the light-emitting element **100,** the sidewall **14** formed of a white resin, and the sealing material **15** for sealing the light-emitting element **100.**

Particles of a single crystal phosphor **41** are dispersed in the sealing material **15.** The phosphor **41** is formed of the single crystal phosphor in the first embodiment and is obtained by, e.g., grinding the single crystal phosphor ingot manufactured in the first embodiment.

The single crystal phosphor **41** dispersed in the sealing material **15** absorbs a portion of bluish light emitted from the light-emitting element **100** and produces yellowish fluorescence having an emission peak at a wavelength of, e.g., **514** to **546** nm. The bluish light, which is not absorbed by the single crystal phosphor **41,** is mixed with the yellowish fluorescence produced by the single crystal phosphor **41** and the light-emitting device **40** thereby emits white light.

The single crystal phosphor **41** in the fifth embodiment may be used in the other embodiments. That is, the single crystal phosphor **41** in the fifth embodiment may be used in place of the single crystal phosphor **21** in the third embodiment.

### [Sixth embodiment]

Next, the ninth embodiment of the invention will be described in reference to **FIG.10. FIG.10** is a vertical cross-sectional view showing a light-emitting device **50** in the sixth embodiment. As shown in **FIG.10**, the sixth embodiment is different from the fifth embodiment in the shape of the sealing material which contains particles of the single crystal phosphor. Constituent elements of the light-emitting device **50** having the same functions and structures as those in the fifth embodiment are denoted by the same reference numerals and the explanation thereof will be omitted.

As shown in **FIG.11**, the light-emitting device **50** has the light-emitting element **100** such as LED, the substrate **11** supporting the light-emitting element **100,** and a sealing material **52** provided to cover the surface of the light-emitting element **100** and the upper surface of the substrate **11.**

Particles of a single crystal phosphor **51** are dispersed in the sealing material **52.** The single crystal phosphor **51** is formed of the single crystal phosphor in the first embodiment and is obtained by, e.g., grinding the single crystal phosphor ingot manufactured in the first embodiment.

The sealing material **52** is, e.g., a transparent resin such as silicone-based resin or epoxy-based resin, or a transparent inorganic material such as glass. The sealing material **52** in the sixth embodiment is formed not only on the surface of the light-emitting element **100** but also on the substrate **11** in some cases because of the manufacturing process using a coating method, but does not need to be formed on the substrate **11.**

The single crystal phosphor **51** dispersed in the sealing material **52** absorbs a portion of bluish light emitted from the light-emitting element **100** and produces yellowish fluorescence having an emission peak at a wavelength of, e.g., **514** to **546** nm. The bluish light, which is not absorbed by the single crystal phosphor **51,** is mixed with the yellowish fluorescence produced by the single crystal phosphor **51** and the light-emitting device **50** thereby emits white light.

Although the embodiments of the invention have been described above, the invention is not intended to be limited to the above-mentioned embodiments and the various kinds of modifications can be implemented within the scope of the claims. In addition, the constituent elements in the above-mentioned embodiments can be arbitrarily combined within the scope of the claims.

In addition, the invention according to claims is not to be limited to the above-mentioned embodiments. Further, it should be noted that all combinations of the features described in the embodiments are not necessary to solve the problem of the invention.

In addition, the above-mentioned embodiments are to provide light-emitting devices having high energy efficiency and realizing energy saving, such as LED light-emitting devices, or to provide single crystal phosphors used for such light-emitting devices, hence, an energy-saving effect is obtained.

### [Industrial Applicability]

The invention provides a YAG-based single crystal phosphor to produce fluorescence in an unconventional color, as well as a phosphor-containing member and a light emitting device including the single crystal phosphor.

### [Reference Signs List]

**10, 20**, **30, 40, 50** LIGHT-EMITTING DEVICE
**13, 21, 31, 41, 51** SINGLE CRYSTAL PHOSPHOR
**100, 200** LIGHT-EMITTING ELEMENT

Examples of the invention are further disclosed in the following.

### [Example 1]

A single crystal phosphor, comprising:
a composition represented by a compositional formula (Y_{**1**-a-b}LuₐCe_{b})_{**3**+c}Al_{**5**-c}O**₁₂** (where **0**≤a≤**0.9994, 0.0002**≤b≤**0.0067**, **-0.016**≤c≤**0.315)**,
wherein CIE chromaticity coordinates x, y of an emission spectrum satisfy a relationship of **-0.4377x** + **0.7384** ≤ y ≤ **-0.4585x** + **0.7504** when a peak wavelength of excitation light is **450** nm and temperature is **25**°C.

### [Example 2]

The single crystal phosphor according to example **1,** wherein a value of "a" in the compositional formula of the single crystal phosphor is in a range of **0.0222**≤a≤**0.9994.**

### [Example 3]

The single crystal phosphor according to example **1,** wherein the value of "a" in the compositional formula of the single crystal phosphor is **0.**

### [Example 4]

A light-emitting device, comprising:
a light-emitting element to emit a bluish light; and
a yellowish phosphor to absorb the light emitted by the light-emitting element and produce a yellowish fluorescence,
wherein the yellowish phosphor comprises the single crystal phosphor according to any one of examples **1** to **3.**

### [Example 5]

The light-emitting device according to example **4,** further comprising a reddish phosphor to absorb the light emitted by the light-emitting element and produce a reddish fluorescence.

### [Example 6]

The light-emitting device according to example **4,** wherein the single crystal phosphor is disposed off from the light-emitting element.

### [Example 7]

The light-emitting device according to example **4,** wherein the single crystal phosphor is plate-shaped.

### [Example 8]

A phosphor-containing member, comprising:
a transparent member; and
particles of phosphor dispersed in the transparent member,
wherein the particles of phosphor comprise the single crystal phosphor according to any one of examples **1** to **3.**

### [Example 9]

The phosphor-containing member according to example **8,** wherein the transparent member comprises a transparent inorganic material.

### [Example 10]

A light-emitting device, comprising:
a light-emitting element to emit a bluish light; and
the phosphor-containing member according to example **8.**

## Claims

1. A phosphor-containing member, comprising:
a transparent member (15, 52); and
particles of a single crystal phosphor (41, 51) dispersed in the transparent member (15,52),
wherein the single crystal phosphor has a composition represented by a compositional formula (Y_{1-a-b}LuₐCe_{b})_{3+c}Al_{5-c}O₁₂ (where 0≤a≤0.9994, 0.0002≤b≤0.0067, -0.016≤c≤0.315),
and CIE chromaticity coordinates x, y of an emission spectrum satisfy a relationship of -0.4377x + 0.7384≤y≤-0.4377x + 0.7504 when a peak wavelength of excitation light is 450nm and temperature is 25°C.

2. The phosphor-containing member according to claim 1, wherein the transparent member (15, 52) is a transparent resin or a transparent inorganic material.

3. The phosphor-containing member according to claim 1 or 2,
wherein a value of "a" in the compositional formula of the single crystal phosphor is in a range of 0.0222≤a≤0.9994.

4. The phosphor-containing member according to claim 1 or 2,
wherein the value of "a" in the compositional formula of the single crystal phosphor is 0.

5. A light-emitting device (40, 50), comprising:
a light-emitting element (100) to emit a bluish light; and
the phosphor containing member according to any one of claims 1 to 4.

## Patentansprüche

1. Leuchtstoffhaltiges Element, umfassend:
ein transparentes Element (15, 52); und
Partikel eines einkristallinen Leuchtstoffs (41, 51), die in dem transparenten Element (15, 52) dispergiert sind,
wobei der einkristalline Leuchtstoff eine Zusammensetzung hat, die repräsentiert ist durch eine Zusammensetzungsformel (Y_{1-a-b}LuₐCe_{b})_{3+c}Al_{5-c}O₁₂ (wobei 0≤a≤0.9994, 0.0002≤b≤0.0067, -0.016≤c≤0.315), und wobei die CIE-Chromatizitätskoordinaten x, y eines Emissionsspektrums eine Beziehung -0.4377x + 0.7384≤y≤ -0.4377x + 0.7504 erfüllen, wenn eine Peakwellenlänge von Anregungslicht 450nm ist, und eine Temperatur 25°C ist.

2. Leuchtstoffhaltiges Element nach Anspruch 1, wobei das transparente Element (15, 52) ein transparentes Harz oder ein transparentes anorganisches Material ist.

3. Leuchtstoffhaltiges Element nach Anspruch 1 oder 2, wobei ein Wert von "a" in der Zusammensetzungsformel des einkristallinen Leuchtstoffs in einem Bereich von 0.0222≤a≤0.9994 ist.

4. Leuchtstoffhaltiges Element nach Anspruch 1 oder 2, wobei der Wert von "a" in der Zusammensetzungsformel des einkristallinen Leuchtstoffs 0 ist.

5. Lichtemittierende Vorrichtung (40, 50), umfassend:
ein lichtemittierendes Element (100) zum Emittieren eines bläulichen Lichts; und
das leuchtstoffhaltige Element nach einem der Ansprüche 1 bis 4.

## Revendications

1. Organe contenant un luminophore, comprenant :
un organe transparent (15, 52) ; et
des particules d'un luminophore monocristallin (41, 51) dispersées dans l'organe transparent (15, 52),
dans lequel le luminophore monocristallin a une composition représentée par une formule de composition (Y_{1-a-b}LuₐCe_{b})_{3+c}Al_{5-c}O₁₂ (où 0 ≤ a ≤ 0,9994,
0,0002 ≤ b ≤ 0,0067, -0,016 ≤ c ≤ 0,315), et des coordonnées x,y de chromaticité CIE d'un spectre d'émission satisfont une relation de -0,4377x + 0,7384 ≤ y ≤ -0,4377x + 0,7504 lorsqu'une longueur d'onde de pointe de lumière d'excitation est de 450 nm et la température est de 25 °C.

2. Organe contenant un luminophore selon la revendication 1, dans lequel l'organe transparent (15, 52) est une résine transparente ou un matériau inorganique transparent.

3. Organe contenant un luminophore selon la revendication 1 ou 2,
dans lequel une valeur de « a » dans la formule de composition du luminophore monocristallin est dans une plage de 0,0222 ≤ a ≤ 0,9994.

4. Organe contenant un luminophore selon la revendication 1 ou 2,
dans lequel la valeur de « a » dans la formule de composition du luminophore monocristallin est de 0.

5. Dispositif électroluminescent (40, 50), comprenant :
un élément électroluminescent (100) pour émettre une lumière bleuâtre ; et
l'organe contenant un luminophore selon l'une quelconque des revendications 1 à 4.
